# EUROPEAN PATENT APPLICATION

(11) **EP 4 050 665 A1**
(43) Date of publication of application: **31.08.2022**
(21) Application number: 20878375.3
(22) Date of filing: 14.10.2020
(51) Int. Cl.: H01L 31/049

(54) **SOLAR BATTERY MODULE**

(30) Priority: 21.10.2019 JP 2019191994
(71) Applicant: Toyo Aluminium Kabushiki Kaisha, Osaka-shi, Osaka 541-0056 (JP)
(72) Inventor: MORI, Keita, Osaka-shi, Osaka 541-0056 (JP); MAEDA, Daisuke, Osaka-shi, Osaka 541-0056 (JP); FUJINO, Takaaki, Osaka-shi, Osaka 541-0056 (JP)
(74) Representative: Marks & Clerk LLP
(86) International application number: PCT/JP2020/038825
(87) International publication number: WO 2021/079808

(57) **Abstract**

The present invention provides a solar cell module attaining reduced cell cracking even when a thin surface glass layer is used, and excellent load-bearing properties. Specifically, the present invention provides a solar cell module comprising, in sequence from a light-receiving surface side, a surface glass layer having a thickness of 0.4 mm or more and 1.6 mm or less, a first sealing layer, cells, a second sealing layer, and a back protective layer, wherein the back protective layer comprises, in sequence from a side closer to the second sealing layer, a first resin sheet layer having a flexural modulus of 1500 MPa or more and 5000 MPa or less, a second resin layer having a maximum bending load of 8N/10 mm or more and 100N/10 mm or less, wherein the maximum bending load is measured by a method in accordance with a bending test (JIS K7171) except that only the span between supports is changed to 48 mm, and a third resin sheet layer having a flexural modulus of 1500 MPa or more and 5000 MPa or less.

## Description

### Technical Field

The present invention relates to a solar cell module.

### Background Art

Solar cell modules usually have a structure in which a surface glass layer having a thickness of about 2.0 to 3.2 mm, a sealing material, crystalline silicon solar cells, a sealing material, and a back protective sheet are layered in sequence.

Since these crystalline solar cell modules have a weight of about 18 kg (= 11 kg/m²) per sheet, there can be restrictions on the installation thereof. For example, it is difficult for a solo operator to install modules in a high place; and due to load-bearing restrictions, solar cell modules sometimes cannot be laid over the surface of the roof of a simple structure, such as a carport.

Under these circumstances, in order to reduce the weight of solar cell modules, as a solar cell module that reduces cell cracking even when a thin surface glass layer is used, Patent Literature 1 suggests a solar cell module comprising, in sequence from a light-receiving surface side, a glass layer having a thickness of 0.8 mm or more and 1.6 mm or less, a first sealing layer, cells, a second sealing layer, and a back protective layer, wherein the back protective layer comprises, in sequence from a side in contact with the second sealing layer, a first resin layer being in a foam state and having a flexural modulus of 200 MPa or more and 1000 MPa or less, and a second resin layer containing glass fiber and having a flexural modulus of 10000 MPa or more and 25000 MPa or less; and the sum of flexural rigidity of the glass layer, the first sealing layer, the second sealing layer, and the back protective layer defined by {(flexural modulus (MPa) × thickness (mm)³)/12} is 4000 MPa·mm³ or more.

### Citation List

### Patent Literature

PTL 1: WO2019/059072

### Summary of Invention

### Technical Problem

However, with the technology disclosed in Patent Literature 1, the solar cell modules do not have sufficient load-bearing properties, and may not be able to be installed in areas where strong wind pressure or substantial snowfall is expected.

The present invention improves the problems of the conventional technology, and aims to provide a solar cell module attaining reduced cell cracking even when a thin surface glass layer is used, and excellent load-bearing properties.

### Solution to Problem

To attain the above object, the present inventors conducted extensive research. As a result, the present inventors found that a solar cell module with a specific layer structure can achieve the above object, and accomplished the present invention.

More specifically, the present invention relates to the following solar cell module.
1. A solar cell module comprising, in sequence from a light-receiving surface side, a surface glass layer having a thickness of 0.4 mm or more and 1.6 mm or less, a first sealing layer, cells, a second sealing layer, and a back protective layer, wherein
   the back protective layer comprises, in sequence from a side closer to the second sealing layer,
   a first resin sheet layer having a flexural modulus of 1500 MPa or more and 5000 MPa or less,
   a second resin layer having a maximum bending load of 8N/10 mm or more and 100N/10 mm or less, wherein the maximum bending load is measured by a method in accordance with a bending test (JIS K7171) except that only the span between supports is changed to 48 mm, and
   a third resin sheet layer having a flexural modulus of 1500 MPa or more and 5000 MPa or less.
2. The solar cell module according to Item 1, wherein the second resin layer comprises at least one layer having a thickness of 0.5 mm or more and 10 mm or less and a density of 100 kg/m³ or more and 700 kg/m³ or less.
3. The solar cell module according to Item 1 or 2, wherein the second resin layer comprises at least one layer comprising a foam body of one or more resins selected from the group consisting of polyethylene resins, polypropylene resins, polystyrene resins, polyurethane resins, polyethylene terephthalate resins, polyvinyl chloride resins, and polymethyl methacrylate resins.
4. The solar cell module according to any one of Items 1 to 3, wherein the second resin layer comprises at least one fiber-reinforced resin layer in which glass fiber is mixed with one or more resins selected from the group consisting of polyethylene resins, polypropylene resins, polyamide resins, polyurethane resins, polycarbonate resins, polymethyl methacrylate resins, polyethylene terephthalate resins, polybutylene terephthalate resins, AS resins, ABS resins, polyacetal resins, polyphenylene sulfide resins, polyether sulfone resins, epoxy resins, vinyl ester resins, phenol resins, unsaturated polyester resins, polyimide resins, PEEK resins, and fluororesins.
5. The solar cell module according to any one of Items 1 to 3,
   wherein the second resin layer comprises at least one fiber-reinforced resin layer having a thickness of 0.2 mm or more and 2.0 mm or less in which glass fiber is mixed with one or more resins selected from the group consisting of polyethylene resins, polypropylene resins, polyamide resins, polyurethane resins, polycarbonate resins, polymethyl methacrylate resins, polyethylene terephthalate resins, polybutylene terephthalate resins, AS resins, ABS resins, polyacetal resins, polyphenylene sulfide resins, polyether sulfone resins, epoxy resins, vinyl ester resins, phenol resins, unsaturated polyester resins, polyimide resins, PEEK resins, and fluororesins.
6. The solar cell module according to any one of Items 1 to 5, wherein the first resin sheet layer and the third resin sheet layer each have a thickness of 0.03 mm or more and 1 mm or less.
7. The solar cell module according to any one of Items 1 to 6, wherein the first resin sheet layer and/or the third resin sheet layer comprise polyethylene terephthalate.
8. The solar cell module according to any one of Items 1 to 7 comprising an easy-adhesion layer on the second sealing layer side of the first resin sheet layer, and a weather-resistant layer on a side opposite to the second resin layer side of the third resin sheet layer.

### Advantageous Effects of Invention

According to the solar cell module of the present invention, a solar cell module attaining reduced cell cracking even when a thin surface glass layer is used and excellent load-bearing properties can be provided.

### Brief Description of Drawings

Fig. 1 is a cross-sectional view schematically illustrating one embodiment of the solar cell module according to the present invention.
Fig. 2 is a cross-sectional view schematically illustrating one embodiment of the solar cell module according to the present invention.

### Description of Embodiments

The solar cell module of the present invention comprises, in sequence from a light-receiving surface side, a surface glass layer having a thickness of 0.4 mm or more and 1.6 mm or less, a first sealing layer, cells, a second sealing layer, and a back protective layer.

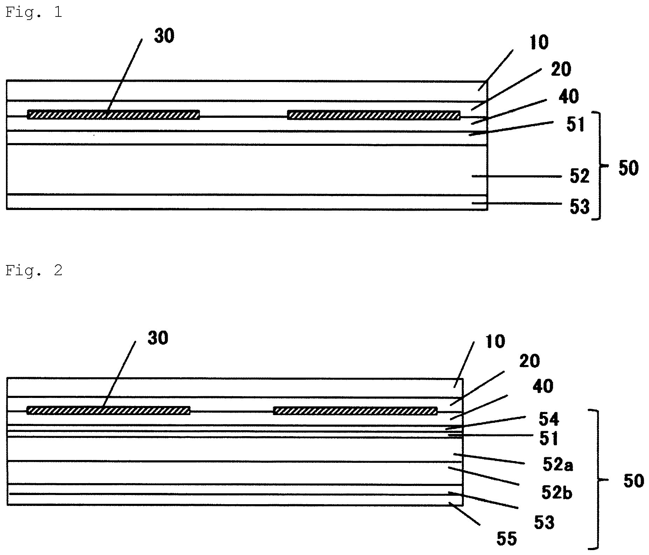

As shown in Fig. 1 as an embodiment of the present invention, the solar cell module comprises, in sequence from the light-receiving surface side, a surface glass layer 10, a first sealing layer 20, cells 30, a second sealing layer 40, and a back protective layer 50.

The back protective layer 50 comprises, in sequence from the side that is in contact with the second sealing layer 40, a first resin sheet layer 51, a second resin layer 52, and a third resin sheet layer 53, which will be described below.

As shown in Fig. 2 as an embodiment of the present invention, the back protective layer 50 of the solar cell module may comprise an easy-adhesion layer 54 on the top side of the first resin sheet layer 51, and a weather-resistant layer 55 on the bottom side of the third resin sheet layer 53.

In the present specification, for example, the side on which the surface glass layer 10 is positioned with respect to the cells 30 (i.e., the light-receiving surface side (sunlight incident side)) is sometimes also referred to as "top side" or "front side"; and the side on which the back protective layer is positioned with respect to the cells 30 is sometimes also referred to as "bottom side" or "back side." In this specification, the range indicated by A to B means "A or more and B or less" unless otherwise specified.

The second resin layer 52 may comprise multiple layers of the same resin or multiple layers of different resins. Further, the first resin sheet layer 51 and the third resin sheet layer 53 may each comprise multiple layers.

The easy-adhesion layer 54 for increasing adhesiveness to the second sealing layer may be further provided on the second sealing layer side, i.e., the front side of the first resin sheet layer 51. Further, the weather-resistant layer 55 with strong UV resistance may be added on the side opposite to the second resin layer side, i.e., the back side of the third resin sheet layer.

The constituent features are described below in detail.

### Surface Glass Layer 10

In the present invention, the surface glass layer has a thickness of 0.4 mm or more and 1.6 mm or less (preferably 0.5 mm or more and 1.2 mm or less). The glass plate used for general solar cell modules has a thickness of about 3.2 mm to 4.2 mm. By using a glass layer having a thickness that is less than half of this thickness, significant weight reduction is possible compared to general solar cells.

Although the type of glass used for the surface glass layer is not particularly limited, physically tempered glass or chemically tempered glass is preferable. If the thickness of the surface glass layer is less than 0.4 mm, the glass may be broken in a hail test. Further, if the thickness of the surface glass layer exceeds 1.6 mm, the weight of the solar cell module when produced is increased, and exceeds a weight that is usually considered to be possible for a woman to work with on her own (body weight 55 kg × 60% × 40% ≈ 13 kg); thus, the installation may be restricted in the same manner as with general solar cell modules.

The surface glass layer used in the present invention preferably has a flexural rigidity defined by {(flexural modulus (MPa) × thickness (mm)³)/12} of 300 MPa·mm³ or more and 21000 MPa· mm³ or less. By setting the flexural rigidity within this range, the cracking of the surface glass layer especially in a load test, and the amount of deflection displacement of the solar cell module can be reduced.

### Sealing Layers 20 and 40

In the present invention, the sealing layers sandwich the front and back surfaces of the cells. The material used for the sealing layers may be any sealing material usually used for sealing cells. In particular, EVA (ethylene-vinyl acetate copolymer) or a polyolefin-based sealing material is preferable. Materials used for the sealing layers are not particularly limited, and known additives may be appropriately added to improve transparency, flexibility, adhesiveness, tensile strength, weatherability, and the like.

In the present invention, the first sealing layer is on the light-receiving surface side of the cells, while the second sealing layer is on the back side of the cells. However, both of these layers usually have substantially the same composition. When the cells are sealed, the first sealing layer and the second sealing layer are fused around the cells. Therefore, in the present invention, the first sealing layer and the second sealing layer are not necessarily clearly distinguished from each other, and can be regarded as a single sealing layer comprising cells inside.

The sealing layer preferably has a flexural rigidity defined by {(flexural modulus (MPa) × thickness (mm)³)/12} of 1 MPa·mm³ or more and 10 MPa·mm³ or less, and more preferably 5 MPa· mm³ or more and 10 MPa·mm³ or less.

In the present specification, the flexural rigidity of the sealing layer refers to the flexural rigidity of a single sealing layer obtained after the first sealing layer and the second sealing layer are fused with each other. The cells present in the single sealing layer do not affect the flexural rigidity of the single sealing layer. By setting the flexural rigidity within the above range, the sealing layer attains excellent flexibility and cell cracking against deflection in a load test can be prevented.

### Cell 30

In the present invention, the cell is a semiconductor that converts the energy of light directly into electricity by the photovoltaic effect.

The type of the cell is not particularly limited, and the cell used may comprise a known semiconductor, such as a silicon (Si) semiconductor; a CIS compound semiconductor comprising copper (Cu), indium (In), and selenium (Se) as starting materials; a CIGS compound semiconductor comprising copper (Cu), indium (In), selenium (Se), and gallium (Ga) as starting materials; a compound semiconductor comprising cadmium (Cd) and tellurium (Te) as starting materials; and a GaAs compound semiconductor comprising gallium (Ga) and arsenic (As) as starting materials.

The cell may further comprise, on the surface or end face thereof, a known wiring or electrode for drawing electricity (interconnector, bus bar, etc.).

### Back Protective Layer 50

In the present invention, the back protective layer is provided on the side opposite to the light-receiving surface side with respect to the cells, and comprises, in sequence from a side in contact with the sealing layer, a first resin sheet layer having a flexural modulus of 1500 MPa or more and 5000 MPa or less; a second resin layer having a maximum bending load of 8N/10 mm or more and 100N/10 mm or less, wherein the maximum bending load is measured by a method in accordance with a bending test (JIS K7171) except that only the span between supports is changed to 48 mm; and a third resin sheet layer having a flexural modulus of 1500 MPa or more and 5000 MPa or less. The first resin sheet layer, the second resin layer, and the third resin sheet layer may each comprise multiple layers.

The back protective layer may comprise one or two or more adhesive layers selected from the group of adhesive layers described later, and other layer(s) for improving water resistance, power generation efficiency, and voltage resistance, between the first resin sheet layers if multiple first resin sheet layers are used, between the first resin sheet layer and the second resin layer, between the second resin layers if multiple second resin layers are used, between the second resin layer and the third resin sheet layer, and between the third resin sheet layers if multiple third resin sheet layers are used. The back protective layer may further comprise a metal layer such as aluminum to improve fire resistance.

An easy-adhesion layer for improving adhesiveness to the sealing layer may be further provided on the front side of the first resin sheet layer, and a weather-resistant layer may be further added to the back side of the third resin sheet layer.

One or two or more adhesive layers selected from the group of adhesive layers described later, and other layer(s) for improving water resistance, power generation efficiency, and voltage resistance may be provided between the first resin sheet layer and the easy-adhesion layer, or between the third resin sheet layer and the weather-resistant layer. Furthermore, a metal layer such as aluminum may be provided to improve fire resistance.

The constituent features of the back protective layer are detailed below.

In general solar cells, a layer called a back protective sheet (back sheet) is provided on the back surface of the solar cells; usually, a laminate of sheets of polyethylene terephthalate (PET), low-density polyethylene, vinylidene fluoride, etc. is used. However, if a thin surface glass layer is used with a conventional back protective sheet as the back protective layer in a solar cell module, the rigidity of the solar cell module will be deteriorated, and cell cracking will occur during transportation or installation. On the other hand, the use of the back protective layer having the structure of the present invention on the back surface of the solar cells can increase the rigidity of the solar cell module comprising a thin surface glass layer.

### First Resin Sheet Layer 51

In the present invention, the first resin sheet layer is a layer close to the second sealing layer in the back protective layer. The resin of the first resin sheet layer is not particularly limited; however, the first resin sheet layer comprises a resin sheet layer with a flexural modulus of 1500 MPa or more and 5000 MPa or less. If the flexural modulus is less than 1500 MPa, the required rigidity in terms of load-bearing properties cannot be obtained. If the flexural modulus exceeds 5000 MPa, problems such that flexibility cannot be obtained and the adhesive has a poor coating property, or the sheet easily cracks occur.

The first resin sheet layer may be a film or sheet with a flexural modulus within the above range, and the type of the resin is not particularly limited. For example, it is possible to use a film or sheet of (meth)acrylic resins, polyvinyl chloride resins, polyvinylidene chloride resins, polycarbonate resins, acetal resins, polyester resins (polyethylene terephthalate, polybutylene terephthalate, and polyethylene naphthalate), polyamide resins, polyphenylene ether resins, and various other resins. These resin films or sheets may be stretched uniaxially or biaxially. Of these, since electrical insulation, handling properties, and the like are ensured, polyester resins are preferable, and polyethylene terephthalate is particularly preferable.

Further, the resin layer can be appropriately colored white, black, or the like. Examples of the coloring means include coating, film formation by pigment kneading, and the like.

For the film-forming method, T-die molding or inflation molding is used. Molding with a multilayer extruder is also possible.

The thickness of the first resin sheet layer is preferably 0.03 mm or more and 1 mm or less, and more preferably 0.05 mm or more and 0.5 mm or less. If the thickness of the first resin sheet layer is less than 0.03 mm, the required rigidity may not be obtained. If the thickness of the second resin sheet layer exceeds 1 mm, it is not possible to roll up the sheet and handling properties are likely to be reduced.

The first resin sheet layer may comprise multiple layers. In the back protective layer, an easy-adhesion layer may be provided on the layer close to the second sealing layer, and the easy-adhesion layer is preferably a layer that can be thermally bonded to the sealing layer by vacuum lamination at a temperature of 130°C or more and 160°C or less.

The type of the resin in the easy-adhesion layer is not particularly limited. For example, it is preferable to contain one or more resins selected from the group consisting of polyethylene resins, polypropylene resins, polystyrene resins, polyurethane resins, polybutene resins, polymethyl methacrylate resins, polyvinyl chloride resins, polyvinyl acetate resins, and polyvinyl alcohol resins, or a copolymer containing the one or more resins. The easy-adhesion resin layer can be prepared in the form of a film, sheet, or coating containing the resin(s) or copolymer in the production process of the solar cell module. These resin films or sheets may be stretched uniaxially or biaxially.

Of these, polyethylene resins (high-density polyethylene, low-density polyethylene, and linear low-density polyethylene) are preferable, and linear low-density polyethylene is more preferable because excellent adhesiveness with EVA, which is a general sealing material of the solar cell module, can be ensured. Linear low-density polyethylene (LLDPE), which has a higher density than low-density polyethylene (LDPE), is preferable for its excellent heat resistance and weatherability.

For the film-forming method, T-die molding or inflation molding is used. Molding with a multilayer extruder is also possible. Further, the resin layer can be appropriately colored white, black, or the like. Examples of the coloring means include coating, film formation by pigment kneading, and the like.

The thickness of the easy-adhesion layer is preferably 1 µm or more and 150 µm or less, and particularly preferably 3 µm or more and 70 µm or less.

### Second Resin Layer 52

In the present invention, the second resin layer of the back protective layer is a layer on a side opposite to the second sealing layer side of the first resin sheet layer, i.e., a layer on the side opposite to the light-receiving surface side.

The second resin layer is a resin layer having a maximum bending load, which is measured by the method in accordance with the bending test (JIS K7171) except that only the span between supports is changed to 48 mm, of 8 N/10 mm or more and 100 N/10 mm or less, and preferably of 10 N/10 mm or more and 60 N/10 mm or less.

If the maximum bending load is smaller than 8 N/10 mm, the load-bearing properties of the solar cell module are reduced. If the maximum bending load is greater than 100 N/10 mm, the weight is increased, and weight reduction cannot be attained.

The type of the resin in the second resin layer is not particularly limited as long as the resin has a maximum bending load within the above range in the above measurement method. For example, one or two or more resins selected from the group consisting of polyethylene resins, polypropylene resins, polystyrene resins, polyurethane resins, polyethylene terephthalate resins, polyvinyl chloride resins, polymethylmethacrylate resins, polyamide resins, polycarbonate resins, polybutylene terephthalate resins, acrylonitrile styrene (AS) resins, acrylonitrile butadiene styrene (ABS) resins, polyacetal resins, polyphenylene sulfide resins, polyethersulfone resins, polyether ether ketone (PEEK) resins, epoxy resins, vinyl ester resins, polyimide resins, unsaturated polyester resins, phenol resins, urea resins, melamine resins, and fluororesins can be used. Of these resins, polypropylene or epoxy resins are particularly preferable in view of strength, heat resistance, and weatherability. To reduce weight, a foam body of the above resin can also be used. Further, a fiber-reinforced resin layer in which glass fiber is mixed with the one or more resins above can be used because deformation against temperature change can be suppressed and excellent dimensional stability can be attained.

Of the above, when the second resin layer is a foam body, the foam body of one or more resins selected from the group consisting of polyethylene resins, polypropylene resins, polystyrene resins, polyurethane resins, polyethylene terephthalate resins, polyvinyl chloride resins, and polymethylmethacrylate resins is preferable.

The second resin layer may comprise multiple layers of the same resin or multiple layers of different resins. Examples include a method of providing two or more resin layers of a foam body, and a method of forming a second resin layer including a resin layer of a foam body and a fiber-reinforced resin layer. If the foam body has two or more resin layers, the layer having a significant bending load despite a light weight can be obtained.

When a foam body is used for the second resin layer, the method of obtaining the second resin layer in a foam state is not limited. For example, known physical foaming or chemical foaming can be used. Further, to obtain the second resin layer in a foam state, the foaming ratio is preferably 1.5-fold or more and 8-fold or less, and particularly preferably 2-fold or more and 5-fold or less. If the foaming ratio is less than 1.5-fold, the density becomes 700 kg/m³ or more, and warping may occur in the solar cell module in vacuum lamination. If the foaming ratio is greater than 8-fold, the density becomes 100 kg/m³ or less, and cracking may occur due to the bending load in a load test, and the cohesion of the resin layer is reduced to easily deform the resin layer when heat is applied.

When a foam body is used for the second resin layer, the second resin layer having a thickness of 0.5 mm or more and 10 mm or less and a density of 100 kg/m³ or more and 700 kg/m³ or less is preferable. If the density exceeds 700 kg/m³, the layer becomes hard and heavy, and heat does not easily escape during vacuum lamination in the production of the solar cell module, which generates residual thermal stress, possibly causing warping of the solar cell module. Furthermore, if the density of the second resin layer is less than 100 kg/m³, the layer becomes too soft, and cracking may occur due to the bending load in a load test; further, foams of the foam body may be broken by hot-pressing at about 150°C in vacuum lamination in the production of the solar cell module.

When the second resin layer is composed of a fiber-reinforced resin layer, glass fiber is preferable as fiber because it has high fire resistance and dimensional stability, and can suppress deformation against temperature change, thus improving the fire resistance and dimensional stability of the module. The resin containing glass fiber is also called glass fiber-reinforced resin (also referred to as "glass FRP," or simply "FRP"), and is obtained by infiltrating fine glass fiber with the resin while maintaining the fiber directionality. The type of glass contained is not particularly limited. For example, a known glass fiber in the form of roving cloth, glass fiber in the form of mat, and the like can be used.

When the second resin layer is a fiber-reinforced resin layer, a fiber-reinforced resin layer in which glass fiber is mixed with one or more resins selected from the group consisting of polyethylene resins, polypropylene resins, polyamide resins, polyurethane resins, polycarbonate resins, polymethylmethacrylate resins, polyethylene terephthalate resins, polybutylene terephthalate resins, AS resins, ABS resins, polyacetal resins, polyphenylene sulfide resins, polyethersulfone resins, epoxy resins, vinyl ester resins, phenol resins, unsaturated polyester resins, polyimide resins, PEEK resins, and fluororesins is preferable.

The fiber-reinforced resin layer is a mixture of resin and glass fiber, and preferably has a thickness of 0.2 mm or more and 2.0 mm or less, and more preferably 0.5 mm or more and 1.0 mm or less. If the thickness is less than 0.2 mm, fire resistance may not be provided due to a low glass fiber content. If the thickness exceeds 2.0 mm, the weight increases, and weight reduction cannot be attained.

The density of the resin layer containing glass fiber is preferably 1500 kg/m³ or more and 2500 kg/m³ or less. If the density is less than 1500 kg/m³, such a density is the same as that of normal resins; specifically, due to the low glass fiber content, the effect of incorporating glass fiber may be reduced. If the density exceeds 2500 kg/m³, the weight may be excessively increased because such a density is the same as that of glass.

The method of forming the resin layer containing glass fiber is not particularly limited, and known resin extrusion and resin liquid impregnation methods can be used. The resin layer containing glass fiber preferably has a flexural modulus of 10000 MPa or more and 45000 MPa or less.

The second resin layer is composed of a single layer or multiple layers, and preferably has an entire thickness of 0.2 mm or more and 10 mm or less. If the thickness of the second resin layer is less than 0.2 mm, rigidity cannot be obtained, and cell cracking may occur. If the entire thickness of the second resin layer exceeds 10 mm, the weight increases. The thickness can be increased while limiting the weight by forming the resin into a foam body to increase the foaming ratio; however, the cohesion of the resin layer is reduced, which may cause the resin layer to easily deform when heat is applied.

### Third Resin Sheet Layer 53

In the present invention, the third resin sheet layer of the back protective layer is a layer on a side opposite to the side of the second resin layer on which the first resin sheet layer is laminated, i.e., on the side opposite to the light-receiving surface. The third resin sheet layer comprises a resin sheet layer having a flexural modulus of 1500 MPa or more and 5000 MPa or less. If the flexural modulus is less than 1500 MPa, the required rigidity in terms of load-bearing properties cannot be obtained. If the flexural modulus exceeds 5000 MPa, problems such that flexibility cannot be obtained and the adhesive has a poor coating property, or the sheet easily cracks occur.

The third resin sheet layer may be a film or sheet with a flexural modulus within the above range, and the type of the resin is not particularly limited. For example, it is possible to use a film or sheet of (meth)acrylic resins, polyvinyl chloride resins, polyvinylidene chloride resins, polycarbonate resins, acetal resins, polyester resins (polyethylene terephthalate, polybutylene terephthalate, and polyethylene naphthalate), polyamide resins, polyphenylene ether (resins, and various other resins. Of these, since electrical insulation, handling properties, and the like are ensured, polyester resins are preferable, and polyethylene terephthalate is particularly preferable. Specifically, the first and/or third resin sheet layers preferably contain polyethylene terephthalate.

These resin films or sheets may be stretched uniaxially or biaxially. Further, the resin layer can be appropriately colored white, black, or the like. Examples of the coloring means include coating, film formation by pigment kneading, and the like.

For the film-forming method, T-die molding or inflation molding is used. Molding with a multilayer extruder is also possible. The third resin sheet layer may comprise multiple layers.

Moreover, a weather-resistant layer may be added on the surface opposite to the second resin layer of the third resin sheet layer. From the viewpoint of weatherability, the resins are not particularly limited. For example, it is possible to use a film or sheet of polyolefin resins such as polyethylene (high-density polyethylene, low-density polyethylene, and linear low-density polyethylene), polypropylene, and polybutene; (meth)acrylic resins; polyvinyl chloride resins; polystyrene resins; polyvinylidene chloride resins; ethylene-vinyl acetate copolymer saponified products; polyvinyl alcohols; polycarbonate resins; fluororesins (polyvinylidene fluoride, polyvinyl fluoride, and ethylene tetrafluoroethylene); polyvinyl acetate resins; acetal resins; polyester resins (polyethylene terephthalate, polybutylene terephthalate, and polyethylene naphthalate); polyamide resins; polyphenylene ether resins; and various other resins.

These resin films or sheets may be stretched uniaxially or biaxially. Of these, since electrical insulation, handling properties, and the like are ensured, polyester resins are preferable. Alternatively, fluororesins (polyvinylidene fluoride, polyvinyl fluoride, and ethylene tetrafluoroethylene) are preferable due to strong UV resistance. Further, the resin layer can be appropriately colored white, black, or the like. Examples of the coloring means include coating, film formation by pigment kneading, and the like.

For the film-forming method, T-die molding or inflation molding is used. Molding with a multilayer extruder is also possible.

The thickness of the third resin sheet layer is preferably 0.03 mm or more and 1 mm or less, and more preferably 0.05 mm or more and 0.5 mm or less. If the thickness of the third resin sheet layer is less than 0.03 mm, the required rigidity may not be obtained. If the thickness of the third resin sheet layer exceeds 1 mm, it is not possible to roll up the sheet and handling properties are likely to be reduced.

### Adhesive Layer

The back protective layer may appropriately comprise an adhesive layer between the first resin sheet layer and the second resin layer, or between the second resin layer and the third resin sheet layer.

The adhesive and the method for adhering the adhesive layer are not particularly limited. For example, a known adhesion method using a two-component curing urethane adhesive, polyether urethane adhesive, polyester adhesive, polyester polyol adhesive, polyester polyurethane polyol adhesive, etc. (adhesive layer group) can be used.

When the first and third resin sheet layers each comprise multiple layers, an easy-adhesion layer is provided on the front side of the first resin sheet layer, or a weather-resistant layer is adhered to the back side of the third resin sheet layer, the adhesive layer preferably has a thickness of 3 µm or more and 30 µm or less, and particularly preferably 5 µm or more and 20 µm or less. When adhesion is performed between the first resin sheet layer and the second resin layer, between layers when the second resin layer comprises multiple layers, and between the second resin layer and the third resin sheet layer, the adhesive layer preferably has a thickness of 10 µm or more and 200 µm or less, and particularly preferably 20 µm or more and 150 µm or less.

### Examples

The present invention is described in detail below with reference to Examples and Comparative Examples. However, the present invention is not limited to these Examples.

### Example 1

First, a transparent polyethylene terephthalate (PET) film having a thickness of 0.125 mm and a flexural modulus of 3300 MPa as a first resin sheet layer, and a white polyethylene (PE) film having a density of 1050 kg/m³ and a thickness of 0.05 mm that serves as an easy-adhesion layer were bonded with a commercially available adhesive.

Second, a foamed polypropylene (PP) sheet having a foaming ratio of 3-fold, a density of 400 kg/m³, and a thickness of 3.0 mm was prepared as a second resin layer. The maximum bending load of the second resin layer was measured by a method in accordance with a bending test (JIS K7171), except that the span between supports was changed to 48 mm. The measured maximum bending load was 8 N/10 mm.

Third, a transparent polyethylene terephthalate (PET) film having a thickness of 0.125 mm and a flexural modulus of 3300 MPa as a third resin sheet layer and a white polyethylene terephthalate (PET) film having a thickness of 0.05 mm that serves as a weather-resistant layer were bonded with a commercially available adhesive.

A dry urethane isocyanate-based adhesive for laminates (thickness: 10 µm) was used to adhere the first resin sheet layer and the easy-adhesion layer, and to adhere the third resin sheet layer and the weather-resistant layer.

A urethane isocyanate-based adhesive for sheet coating (thickness: 70 µm) was used to adhere the first resin sheet layer, the second resin layer, and the third resin sheet layer, thereby obtaining a back protective layer. The maximum bending load of the back protective layer was measured by a method in accordance with a bending test (JIS K7171), except that the span between supports was changed to 64 mm. The measured maximum bending load was 48 N/10 mm.

In the present specification, the maximum bending load of the entire back protective layer is a value measured in accordance with a bending test (JIS K7171), except that the span between supports is changed to 64 mm, and the maximum bending load of the second resin layer is a value measured in accordance with a bending test (JIS K7171), except that the span between supports is changed to 48 mm (the same applies below).

Tempered glass having a density of 2500 kg/m³, a flexural modulus of 60000 MPa, and a size of 1323 mm (length) × 990 mm (width) × 0.85 mm (thickness) was prepared as a surface glass layer; two EVAs having the same dimension as the surface glass layer, and having a density of 960 kg/m³, a flexural modulus of 100 MPa, and a thickness of 0.5 mm were prepared as sealing layers; and 48 single-crystalline cells, each having a size of 156 mm (length) × 156 mm (width) × 200 µm (thickness), were prepared. Then, a commercially available interconnector (Hitachi Metals, Ltd.) and bus bar (Hitachi Metals, Ltd.) were attached to the cells.

The surface glass layer, the first sealing layer, the cells, the second sealing layer, and the back protective layer were placed in sequence on a hot plate of a vacuum laminator, and lamination was carried out at 140°C for 15 minutes. The cells were arranged in 6 rows in the lateral direction and 8 rows in the longitudinal direction, with respect to the surface glass layer. In this manner, a solar cell module including the surface glass layer, the first sealing layer, the cells, the second sealing layer, and the back protective layer stacked in sequence was obtained. This solar cell module had a size of 1323 mm in length and 990 mm in width, and was a 48-cell series module with a weight of 5.5 kg/m².

Subsequently, evaluation tests based on IEC61215 and JIS C8990 were performed on this solar cell module. An evaluation test was performed by subjecting the module to a dump-heat (DH) test for 1000 hours. Thereafter, the solar cell module was fixed to a metal frame or a metal rack along the four sides, and a load test was performed that included 3 cycles of a test of applying a uniformly distributed load alternately to the front side and back side of the module for 1 hour each.

In accordance with the IEC standard, a solar cell module with 2400 Pa × safety factor 1.5 = 3600 Pa or more and having no cracks on the cells or surface glass layer was classified as pass (A), and a solar cell module with cracks on the cell or surface glass layer was classified as failure (B).

Example 1 resulted in pass (A) in the load test. Tables 1 and 2 below show the conditions and the module physical properties of the Examples and Comparative Examples. The test methods and evaluation criteria described in Example 1 were also applied in the same manner in other Examples and Comparative Examples.

### Example 2

A back protective layer and a solar cell module were obtained in the same manner as in Example 1, except that the second resin layer was changed to a foamed polypropylene (PP) sheet having a foaming ratio of 3-fold, a density of 400 kg/m³, a flexural modulus of 400 MPa, and a thickness of 5.0 mm.

The maximum bending load of the second resin layer was measured by a method in accordance with a bending test (JIS K7171), except that only the span between supports was changed to 48 mm. The measured maximum bending load was 32 N/10 mm.

The maximum bending load of the back protective layer was measured in accordance with a bending test (JIS K7171), except that only the span between supports was changed to 64 mm. The measured maximum bending load was 55 N/10 mm. The solar cell module had a weight of 6.1 kg/m².

Example 2 resulted in pass (A) in the load test.

### Example 3

A back protective layer and a solar cell module were obtained in the same manner as in Example 1, except that the second resin layer was changed to a multilayer formed of second resin layer a and second resin layer b. Second resin layer a was a foamed polypropylene (PP) sheet having a foaming ratio of 3-fold, a density of 400 kg/m³, a flexural modulus of 400 MPa, and a thickness of 2.0 mm, and second resin layer b was a foamed polypropylene (PP) sheet having a foaming ratio of 3-fold, a density of 400 kg/m³, a flexural modulus of 400 MPa, and a thickness of 2.0 mm.

An urethane isocyanate-based adhesive for sheet coating (thickness: 70 µm) was used to adhere second resin layer a and second resin layer b.

The maximum bending load of the second resin layer was measured by a method in accordance with a bending test (JIS K7171), except that only the span between supports was changed to 48 mm. The measured maximum bending load was 20 N/10 mm.

The maximum bending load of the back protective layer was measured in accordance with a bending test (JIS K7171), except that the span between supports was changed to 64 mm. The measured maximum bending load was 44 N/10 mm. The solar cell module had a weight of 5.9 kg/m².

Example 3 resulted in pass (A) in the load test.

### Example 4

A back protective layer and a solar cell module were obtained in the same manner as in Example 1, except that the second resin layer was changed to a multilayer formed of second resin layer a and second resin layer b. Second resin layer a was a foamed polypropylene (PP) sheet having a foaming ratio of 3-fold, a density of 400 kg/m³, a flexural modulus of 400 MPa, and a thickness of 3.0 mm, and second resin layer b was a foamed polypropylene (PP) sheet having a foaming ratio of 3-fold, a density of 400 kg/m³, a flexural modulus of 400 MPa, and a thickness of 2.0 mm.

A urethane isocyanate-based adhesive for sheet coating (thickness: 70 µm) was used to adhere second resin layer a and second resin layer b.

The maximum bending load of the second resin layer was measured by a method in accordance with a bending test (JIS K7171), except that only the span between supports was changed to 48 mm. The measured maximum bending load was 32 N/10 mm.

The maximum bending load of the back protective layer was measured in accordance with a bending test (JIS K7171), except that the span between supports was changed to 64 mm. The measured maximum bending load was 56 N/10 mm. The solar cell module had a weight of 6.2 kg/m².

Example 4 resulted in pass (A) in the load test.

### Example 5

A back protective layer and a solar cell module were obtained in the same manner as in Example 1, except that the second resin layer was changed to a multilayer formed of second resin layer a and second resin layer b. Second resin layer a was a foamed polypropylene (PP) sheet having a foaming ratio of 3-fold, a density of 400 kg/m³, a flexural modulus of 400 MPa, and a thickness of 3.0 mm, and second resin layer b was a foamed polypropylene (PP) sheet having a foaming ratio of 3-fold, a density of 400 kg/m³, a flexural modulus of 400 MPa, and a thickness of 3.0 mm.

A urethane isocyanate-based adhesive for sheet coating (thickness: 70 µm) was used to adhere second resin layer a and second resin layer b.

The maximum bending load of the second resin layer was measured by a method in accordance with a bending test (JIS K7171), except that only the span between supports was changed to 48 mm. The measured maximum bending load was 54 N/10 mm.

The maximum bending load of the back protective layer was measured in accordance with a bending test (JIS K7171), except that the span between supports was changed to 64 mm. The measured maximum bending load was 78 N/10 mm. The solar cell module had a weight of 6.5 kg/m².

Example 5 resulted in pass (A) in the load test.

### Example 6

A back protective layer and a solar cell module were obtained in the same manner as in Example 1, except that the second resin layer was changed to a multilayer formed of second resin layer a and second resin layer b. Second resin layer a was a foamed polypropylene (PP) sheet having a foaming ratio of 3-fold, a density of 400 kg/m³, a flexural modulus of 400 MPa, and a thickness of 3.0 mm, and second resin layer b was a glass cloth-reinforced polypropylene resin-based FRP (glass fiber density: 70 wt%) having a density of 1600 kg/m³ and a thickness of 0.5 mm.

A urethane isocyanate-based adhesive for sheet coating (thickness: 70 µm) was used to adhere second resin layer a and second resin layer b.

The maximum bending load of the second resin layer was measured by a method in accordance with a bending test (JIS K7171), except that only the span between supports was changed to 48 mm. The measured maximum bending load was 35 N/10 mm.

The maximum bending load of the back protective layer was measured in accordance with a bending test (JIS K7171), except that the span between supports was changed to 64 mm. The measured maximum bending load was 55 N/10 mm. The solar cell module had a weight of 6.4 kg/m².

Example 6 resulted in pass (A) in the load test.

### Example 7

A solar cell module was obtained in the same manner as in Example 6, except that the thickness of the surface glass layer was changed from 0.85 mm to 0.55 mm, and the weight of the solar cell module was accordingly changed to 5.6 kg/m².

Example 7 resulted in pass (A) in the load test.

### Example 8

Transparent polyethylene terephthalate (PET) films having a thickness of 0.25 mm and a flexural modulus of 3300 MPa were prepared as a first resin sheet layer and a third resin sheet layer.

Subsequently, the second resin layer was prepared in the form of a multilayer of second resin layer a and second resin layer b. Second resin layer a was a foamed polypropylene (PP) sheet having a foaming ratio of 3-fold, a density of 400 kg/m³, a flexural modulus of 400 MPa, and a thickness of 2.0 mm, and second resin layer b was a foamed polypropylene (PP) sheet having a foaming ratio of 3-fold, a density of 400 kg/m³, a flexural modulus of 400 MPa, and a thickness of 2.0 mm. A urethane isocyanate-based adhesive for sheet coating (thickness: 70 µm) was used to adhere the first resin sheet layer, the second resin layer, and the third resin sheet layer. In this manner, a back protective layer was obtained.

The maximum bending load of the second resin layer was measured by a method in accordance with a bending test (JIS K7171), except that only the span between supports was changed to 48 mm. The measured maximum bending load was 20 N/10 mm.

The maximum bending load of the back protective layer was measured in accordance with a bending test (JIS K7171), except that the span between supports was changed to 64 mm. The measured maximum bending load was 50 N/10 mm.

A solar cell module was obtained in the same manner as in Example 1, except for the back protective layer described above. The solar cell module had a weight of 5.8 kg/m².

Example 8 resulted in pass (A) in the load test.

### Example 9

A back protective layer and a solar cell module were obtained in the same manner as in Example 1, except that the second resin layer was changed to a polycarbonate sheet having a thickness of 1.5 mm.

The maximum bending load of the second resin layer was measured by a method in accordance with a bending test (JIS K7171), except that only the span between supports was changed to 48 mm. The measured maximum bending load was 24 N/10 mm.

The maximum bending load of the back protective layer was measured in accordance with a bending test (JIS K7171), except that the span between supports was changed to 64 mm. The measured maximum bending load was 60 N/10 mm. The solar cell module had a weight of 6.4 kg/m².

Example 9 resulted in pass (A) in the load test.

### Example 10

A back protective layer and a solar cell module were obtained in the same manner as in Example 1, except that the second resin layer was changed to a multilayer formed of second resin layer a and second resin layer b. Second resin layer a was a foamed polypropylene (PP) sheet having a foaming ratio of 3-fold, a density of 400 kg/m³, a flexural modulus of 400 MPa, and a thickness of 3.0 mm, and second resin layer b was a glass cloth-reinforced epoxy resin-based FRP (glass fiber density: 80 wt%) having a density of 2100 kg/m³ and a thickness of 0.5 mm.

A urethane isocyanate-based adhesive for sheet coating (thickness: 70 µm) was used to adhere second resin layer a and second resin layer b.

The maximum bending load of the second resin layer was measured by a method in accordance with a bending test (JIS K7171), except that only the span between supports was changed to 48 mm. The measured maximum bending load was 48 N/10 mm.

The maximum bending load of the back protective layer was measured in accordance with a bending test (JIS K7171), except that the span between supports was changed to 64 mm. The measured maximum bending load was 61 N/10 mm. The solar cell module had a weight of 6.7 kg/m².

Example 10 resulted in pass (A) in the load test.

### Example 11

A back protective layer and a solar cell module were obtained in the same manner as in Example 1, except that the second resin layer was changed to a glass cloth-reinforced epoxy resin-based FRP (glass fiber density: 80 wt%) having a density of 2100 kg/m³ and a thickness of 1 mm.

The maximum bending load of the second resin layer was measured by a method in accordance with a bending test (JIS K7171), except that only the span between supports was changed to 48 mm. The measured maximum bending load was 63 N/10 mm.

The maximum bending load of the back protective layer was measured in accordance with a bending test (JIS K7171), except that the span between supports was changed to 64 mm. The measured maximum bending load was 64 N/10 mm. The solar cell module had a weight of 6.7 kg/m².

Example 11 resulted in pass (A) in the load test.

### Comparative Example 1

A back protective layer and a solar cell module were obtained in the same manner as in Example 1, except that the second resin layer was changed to a foamed polypropylene (PP) sheet having a foaming ratio of 3-fold, a density of 400 kg/m³, a flexural modulus of 400 MPa, and a thickness of 2.0 mm.

The maximum bending load of the second resin layer was measured by a method in accordance with a bending test (JIS K7171), except that only the span between supports was changed to 48 mm. The measured maximum bending load was 4 N/10 mm.

The maximum bending load of the back protective layer was measured in accordance with a bending test (JIS K7171), except that the span between supports was changed to 64 mm. The measured maximum bending load was 20 N/10 mm. The solar cell module had a weight of 5.2 kg/m².

Comparative Example 1 resulted in failure (B) in the load test.

### Comparative Example 2

A solar cell module was obtained in the same manner as in Example 1, except that the first resin sheet layer, the third resin sheet layer, the easy-adhesion layer, and the weather-resistant layer were excluded, and the second resin layer was changed to a multilayer formed of second resin layer a and second resin layer b to obtain a back protective layer. Second resin layer a was a foamed polypropylene (PP) sheet having a foaming ratio of 3-fold, a density of 400 kg/m³, a flexural modulus of 400 MPa, and a thickness of 3.0 mm, and second resin layer b was a foamed polypropylene (PP) sheet having a foaming ratio of 3-fold, a density of 400 kg/m³, a flexural modulus of 400 MPa, and a thickness of 2.0 mm.

A urethane isocyanate-based adhesive for sheet coating (thickness: 70 µm) was used to adhere second resin layer a and second resin layer b.

The maximum bending load of the second resin layer was measured by a method in accordance with a bending test (JIS K7171), except that only the span between supports was changed to 48 mm. The measured maximum bending load was 32 N/10 mm.

The maximum bending load of the back protective layer was measured in accordance with a bending test (JIS K7171), except that the span between supports was changed to 64 mm. The measured maximum bending load was 21 N/10 mm. The solar cell module had a weight of 5.5 kg/m².

Comparative Example 2 resulted in failure (B) in the load test.

### Comparative Example 3

A solar cell module was obtained in the same manner as in Example 1, except that the first resin sheet layer, the third resin sheet layer, the easy-adhesion layer, and the weather-resistant layer were excluded, and the second resin layer was changed to a multilayer formed of second resin layer a and second resin layer b to obtain a back protective layer. Second resin layer a was a foamed polypropylene (PP) sheet having a foaming ratio of 3-fold, a density of 400 kg/m³, a flexural modulus of 400 MPa, and a thickness of 3.0 mm, and second resin layer b was a glass cloth-reinforced polypropylene resin-based FRP (glass fiber density: 70 wt%) having a density of 1600 kg/m³ and a thickness of 0.5 mm.

A urethane isocyanate-based adhesive for sheet coating (thickness: 70 µm) was used to adhere second resin layer a and second resin layer b.

The maximum bending load of the second resin layer was measured by a method in accordance with a bending test (JIS K7171), except that only the span between supports was changed to 48 mm. The measured maximum bending load was 35 N/10 mm.

The maximum bending load of the back protective layer was measured in accordance with a bending test (JIS K7171), except that the span between supports was changed to 64 mm. The measured maximum bending load was 15 N/10 mm. The solar cell module had a weight of 5.7 kg/m².

Comparative Example 3 resulted in failure (B) in the load test.

### Comparative Example 4

A solar cell module was obtained in the same manner as in Example 1, except that the first resin sheet layer, the third resin sheet layer, and the weather-resistant layer were excluded, a white polyethylene (PE) film having a density of 1050 kg/m³, a tensile modulus of elasticity of 1000 MPa, and a thickness of 0.05 mm was used as an easy-adhesion layer, and the second resin layer was changed to a multilayer formed of second resin layer a and second resin layer b to obtain a back protective layer. Second resin layer a was a foamed polypropylene (PP) sheet having a foaming ratio of 3-fold, a density of 400 kg/m³, a flexural modulus of 400 MPa, and a thickness of 3.0 mm, and second resin layer b was a glass cloth-reinforced polypropylene resin-based FRP (glass fiber density: 70 wt%) having a density of 1600 kg/m³ and a thickness of 0.5 mm.

A urethane isocyanate-based adhesive for sheet coating (thickness: 70 µm) was used to adhere the easy-adhesion layer and the second resin layer, and to adhere second resin layer a and second resin layer b. The maximum bending load of the second resin layer was measured by a method in accordance with a bending test (JIS K7171), except that only the span between supports was changed to 48 mm. The measured maximum bending load was 35 N/10 mm.

The maximum bending load of the back protective layer was measured in accordance with a bending test (JIS K7171), except that the span between supports was changed to 64 mm. The measured maximum bending load was 18 N/10 mm. The solar cell module had a weight of 5.9 kg/m².

Comparative Example 4 resulted in failure (B) in the load test.

### Comparative Example 5

A back protective layer and a solar cell module were obtained in the same manner as in Example 2, except that the third resin sheet layer and the weather-resistant layer were excluded.

The maximum bending load of the second resin layer was measured by a method in accordance with a bending test (JIS K7171), except that only the span between supports was changed to 48 mm. The measured maximum bending load was 8 N/10 mm.

The maximum bending load of the back protective layer was measured in accordance with a bending test (JIS K7171), except that the span between supports was changed to 64 mm. The measured maximum bending load was 14 N/10 mm. The solar cell module had a weight of 5.3 kg/m².

Comparative Example 5 resulted in failure (B) in the load test.

### Comparative Example 6

A back protective layer and a solar cell module were obtained in the same manner as in Example 2, except that the first resin sheet layer and the easy-adhesion layer were excluded.

The maximum bending load of the second resin layer was measured by a method in accordance with a bending test (JIS K7171), except that only the span between supports was changed to 48 mm. The measured maximum bending load was 32 N/10 mm.

The maximum bending load of the back protective layer was measured in accordance with a bending test (JIS K7171), except that the span between supports was changed to 64 mm. The measured maximum bending load was 20 N/10 mm. The solar cell module had a weight of 5.9 kg/m².

Comparative Example 6 resulted in failure (B) in the load test.

**Table 1**

| | Thickness (mm) | | | | | | | Maximum Bending Load of Back Protective Layer (N/10 mm) | Total Weight (kg/m²) | Module Physical Properties |
|---|---|---|---|---|---|---|---|---|---|---|
| | Surface Glass Layer | Easy-adhesion Resin Layer | First Resin Sheet Layer | Second Resin Layer a | Second Resin Layer b | Third Resin Sheet Layer | Weather-resistant Layer | | | Load Test after DH (Pass/Fail) |
| Ex. 1 | 0.85 | 0.05 | 0.125 | 3.0 | - | 0.125 | 0.05 | 48 | 5.5 | A |
| Ex. 2 | 0.85 | 0.05 | 0.125 | 5.0 | - | 0.125 | 0.05 | 55 | 6.1 | A |
| Ex. 3 | 0.85 | 0.05 | 0.125 | 2.0 | 2.0 | 0.125 | 0.05 | 44 | 5.9 | A |
| Ex. 4 | 0.85 | 0.05 | 0.125 | 3.0 | 2.0 | 0.125 | 0.05 | 56 | 6.2 | A |
| Ex. 5 | 0.85 | 0.05 | 0.125 | 3.0 | 3.0 | 0.125 | 0.05 | 78 | 6.5 | A |
| Ex. 6 | 0.85 | 0.05 | 0.125 | 3.0 | 0.5 | 0.125 | 0.05 | 55 | 6.4 | A |
| Ex. 7 | 0.55 | 0.05 | 0.125 | 3.0 | 0.5 | 0.125 | 0.05 | 55 | 5.6 | A |
| Ex. 8 | 0.85 | - | 0.250 | 2.0 | 2.0 | 0.250 | - | 50 | 5.8 | A |
| Ex. 9 | 0.85 | 0.05 | 0.125 | 1.5 | - | 0.125 | 0.05 | 60 | 6.4 | A |
| Ex. 10 | 0.85 | 0.05 | 0.125 | 3.0 | 0.5 | 0.125 | 0.05 | 61 | 6.7 | A |
| Ex. 11 | 0.85 | 0.05 | 0.125 | 1.0 | - | 0.125 | 0.05 | 64 | 6.7 | A |

**Table 2**

| | Thickness (mm) | | | | | | | Maximum Bending Load of Back Protective Layer (N/10 mm) | Total Weight (kg/m²) | Module Physical Properties |
|---|---|---|---|---|---|---|---|---|---|---|
| | Surface Glass Layer | Easy-adhesion Resin Layer | First Resin Sheet Layer | Second Resin Layer a | Second Resin Layer b | Third Resin Sheet Layer | Weather-resistant Layer | | | Load Test after DH (Pass/Fail) |
| Com. Ex. 1 | 0.85 | 0.05 | 0.125 | 2.0 | - | 0.125 | 0.05 | 20 | 5.2 | B |
| Com. Ex. 2 | 0.85 | - | - | 3.0 | 2.0 | - | - | 21 | 5.5 | B |
| Com. Ex. 3 | 0.85 | - | - | 3.0 | 0.5 | - | - | 15 | 5.7 | B |
| Com. Ex. 4 | 0.85 | 0.05 | - | 3.0 | 0.5 | - | - | 18 | 5.9 | B |
| Com. Ex. 5 | 0.85 | 0.05 | 0.125 | 3.0 | - | - | - | 14 | 5.3 | B |
| Com. Ex. 6 | 0.85 | - | - | 5.0 | - | 1.25 | 0.05 | 20 | 5.9 | B |

The results above revealed that the solar cell modules including, in sequence from the light-receiving surface side, a surface glass layer having a thickness of 0.4 mm or more and 1.6 mm or less, a first sealing layer, cells, a second sealing layer, and a back protective layer, wherein the back protective layer includes, in sequence from the side closer to the second sealing layer, a first resin sheet layer having a flexural modulus of 1500 MPa or more and 5000 MPa or less, a second resin layer having a maximum bending load of 8 N/10 mm or more and 100 N/10 mm or less measured by a method in accordance with a bending test (JIS K7171), except that only the span between supports was changed to 48 mm, and a third resin sheet layer having a flexural modulus of 1500 MPa or more and 5000 MPa or less were light yet exhibited reduced cracks in the cells, and had load-bearing properties sufficient to prevent the cells from cracking, in particular, even at a value of above 2400 Pa × safety factor 1.5 = 3600 Pa or more.

### Description of the Reference Numerals

10: Surface glass layer
20: First sealing layer
30: Cell
40: Second sealing layer
50: Back protective layer
51: First resin sheet layer
52 (a,b): Second resin layer
53: Third resin sheet layer
54: Easy-adhesion layer
55: Weather-resistant layer

## Claims

1. A solar cell module comprising, in sequence from a light-receiving surface side, a surface glass layer having a thickness of 0.4 mm or more and 1.6 mm or less, a first sealing layer, cells, a second sealing layer, and a back protective layer,
wherein
the back protective layer comprises, in sequence from a side closer to the second sealing layer,
a first resin sheet layer having a flexural modulus of 1500 MPa or more and 5000 MPa or less, a second resin layer having a maximum bending load of 8N/10 mm or more and 100N/10 mm or less, wherein the maximum bending load is measured by a method in accordance with a bending test (JIS K7171) except that only the span between supports is changed to 48 mm, and
a third resin sheet layer having a flexural modulus of 1500 MPa or more and 5000 MPa or less.

2. The solar cell module according to claim 1, wherein the second resin layer comprises at least one layer having a thickness of 0.5 mm or more and 10 mm or less and a density of 100 kg/m³ or more and 700 kg/m³ or less.

3. The solar cell module according to claim 1 or 2, wherein the second resin layer comprises at least one layer comprising a foam body of one or more resins selected from the group consisting of polyethylene resins, polypropylene resins, polystyrene resins, polyurethane resins, polyethylene terephthalate resins, polyvinyl chloride resins, and polymethyl methacrylate resins.

4. The solar cell module according to any one of claims 1 to 3, wherein the second resin layer comprises at least one fiber-reinforced resin layer in which glass fiber is mixed with one or more resins selected from the group consisting of polyethylene resins, polypropylene resins, polyamide resins, polyurethane resins, polycarbonate resins, polymethyl methacrylate resins, polyethylene terephthalate resins, polybutylene terephthalate resins, AS resins, ABS resins, polyacetal resins, polyphenylene sulfide resins, polyether sulfone resins, epoxy resins, vinyl ester resins, phenol resins, unsaturated polyester resins, polyimide resins, PEEK resins, and fluororesins.

5. The solar cell module according to any one of claims 1 to 3, wherein the second resin layer comprises at least one fiber-reinforced resin layer having a thickness of 0.2 mm or more and 2.0 mm or less in which glass fiber is mixed with one or more resins selected from the group consisting of polyethylene resins, polypropylene resins, polyamide resins, polyurethane resins, polycarbonate resins, polymethyl methacrylate resins, polyethylene terephthalate resins, polybutylene terephthalate resins, AS resins, ABS resins, polyacetal resins, polyphenylene sulfide resins, polyether sulfone resins, epoxy resins, vinyl ester resins, phenol resins, unsaturated polyester resins, polyimide resins, PEEK resins, and fluororesins.

6. The solar cell module according to any one of claims 1 to 5, wherein the first resin sheet layer and the third resin sheet layer each have a thickness of 0.03 mm or more and 1 mm or less.

7. The solar cell module according to any one of claims 1 to 6, wherein the first resin sheet layer and/or the third resin sheet layer comprise polyethylene terephthalate.

8. The solar cell module according to any one of claims 1 to 7 comprising an easy-adhesion layer on the second sealing layer side of the first resin sheet layer, and a weather-resistant layer on a side opposite to the second resin layer side of the third resin sheet layer.
